# EUROPÄISCHE PATENTSCHRIFT

(11) **EP 0 752 277 B1**
(45) Veröffentlichungstag und Bekanntmachung des Hinweises auf die Patenterteilung: **17.10.2001**
(21) Anmeldenummer: 96110645.7
(22) Anmeldetag: 02.07.1996
(51) Int. Cl.: B05C 9/00, B65G 47/00, B65G 49/00, H05K 3/00

(54) **Vorrichtung zum Behandeln von flexiblen platten- bzw. blattförmigen Gegenständen, insbesondere Leiterplatten**
Apparatus for heating flexible plate-foil like articles, in particular printed circuit boards
Dispositif pour le traitement de produits flexibles en forme de plaque ou de feuille, e.p. des circuits imprimés

(30) Priorität: 06.07.1995 DE 19524562
(43) Veröffentlichungstag der Anmeldung: 08.01.1997
(73) Patentinhaber: Gebr. Schmid GmbH & Co., D-72250 Freudenstadt (DE)
(72) Erfinder: Schmid, Dieter C., 72250 Freudenstadt (DE)
(74) Vertreter: Patentanwälte Ruff, Wilhelm, Beier, Dauster & Partner

(56) Entgegenhaltungen:
- EP-A- 0 037 483
- EP-A- 0 315 581
- EP-A- 0 416 775
- FR-A- 2 558 976
- US-A- 5 176 158
- PATENT ABSTRACTS OF JAPAN vol. 012, no. 047 (C-475), 12.Februar 1988 & JP 62 192587 A (FUJITSU LTD), 24.August 1987,

## Beschreibung

### Anwendungsgebiet und Stand der Technik

Die Erfindung betrifft eine Vorrichtung zum Behandeln von platten- bzw. blattförmigen Gegenständen, insbesondere Leiterplatten, mit Aufbringemitteln zur Aufbringung eines flüssigen Behandlungsmediums, insbesondere durch Sprühen, wobei zumindest in einem Behandlungsabschnitt die Gegenstände längs einer Förderbahn etwa horizontal angeordnet durch die Vorrichtung transportiert werden, wobei die Förderbahn zumindest im Randbereich gegenüber der Horizontalen geneigt ist.

Bei der Herstellung von Leiterplatten werden diese unterschiedlichen Behandlungen ausgesetzt, beispielsweise physikalischen oder chemischen Aufbringungen von Schichten, Behandlungen mit Entwicklerlösungen, Ätz- und Reinigungsvorgängen.

Darunter sind auch Behandlungen, die chemische oder physikalische Reaktionen beinhalten, die von der Behandlungszeit und/oder der Intensität des Stoffaustausches, beispielsweise mit dem Behandlungsmedium, abhängig sind. Deswegen ist es in der EP 504 656 schon vorgeschlagen worden, eine Behandlung von unten her vorzunehmen, damit das Behandlungsmedium sofort nach der Aufbringung wieder abtropfen kann und somit die Reaktionszeit überall relativ gleichmäßig ist und stets wieder Platz für neues Behandlungsmedium gemacht werden kann.

Da diese Behandlung in der Serienfertigung stets in kontinuierlichem Durchlauf erfolgen sollte, wandern dabei die Gegenstände durch die Behandlungsstation. Ihr Transport wird um so kritischer, je dünner die Gegenstände werden. Der Transport sehr dünner plattenförmiger Gegenstände, die bei der Leiterplattenfertigung schon fast als blattförmig zu bezeichnen sind und deren Dicke nur noch im Bereich von hundertstel Millimetern liegt, erfordert aber ein sehr aufwendiges und wenig Freiräume lassendes Transportsystem, das eine Behandlung von unten her erschwert. Daher ist in der nicht vorveröffentlichten deutschen Patentanmeldung 195 09 313.5 vorgeschlagen worden, die Gegenstände durch auf ihre Oberseite ausgeübte Saugwirkung an einem oben liegenden Transporteur mit freier Unterseite zu transportieren und so die Behandlung ungestört vornehmen zu können.

Aus der JP-62 192587A (Patent Abstract of Japan Vol. 012, Nr. 047 vom 12. Februar 1988) ist eine Vorrichtung nach dem Oberbegriff des Anspruchs 1 bekanntgeworden. Sie enthält eine Reihe von dünnen, einander überlappenden Scheiben, die, in Querrichtung zur Transport gesehen, einen gewölbten Verlauf der darauf geförderten Gegenstände vorgeben. Dadurch wird das Stagnieren der Behandlungsflüssigkeit auf der Leiterplatte vermieden. Die Art der Förderbahn mit Linienberührung ist aber recht schädlich für die empfindlichen Oberflächen der Leiterplatten während ihrer Behandlung, und die genaue Spurhaltung der Leiterplatten über die Behandlungsstrecke ist schwer sicherzustellen.

Aus der FR-2 558 976 A ist ein Verschiebetisch für Folien bekanntgeworden, der mit einem luftdurchlässigen, endlosen Band arbeitet. Unter dem Band ist ein Saugkasten vorgesehen. Die Vorrichtung dient zur Positionierung der Folie unter einer Vorrichtung zum Markieren oder dgl..

### Aufgabe und Lösung

Ausgehend von diesen Voraussetzungen hat die Erfindung es sich zur Aufgabe gemacht, die eingangs erwähnte Vorrichtung unter Vermeidung aller Nachteile des Standes der Technik zu verbessern und weiterzuentwickeln, insbesondere eine Vorrichtung zu schaffen, bei der die Gegenstände schonend und trotzdem unter der Voraussetzung gleichmäßiger Behandlungszeiten und guten Materialaustausches durch eine Behandlungsstation zu transportieren.

Diese Aufgabe wird erfindungsgemäß dadurch gelöst, daß die Förderbahn wenigstens einen Bandförderer enthält und daß die Förderbahn die Anlage der Gegenstände an der Förderbahn unterstützende Anlegemittel aufweist. Besonders bevorzugt ist eine Ausführung, bei der die Förderbahn quer zur Förderrichtung gekrümmt ist. Durch die Neigung wird praktisch in allen Bereichen eines plattenförmigen Gegenstandes dafür gesorgt, daß eine eindeutige Ablaufrichtung vorhanden ist. Bei gekrümmter Ausführung kann dafür gesorgt werden, daß die Ablaufstrecke minimiert wird. Pfützenbildung, die zu verlängerten Reaktionzeiten einerseits und zur Verhinderung eines schnellen Materialaustausches andererseits führen würden und damit unkontrollierbare Ergebnisse ergeben könnte, wird vermieden.

Die Krümmung des Gegenstandes hat außer der Tatsache, daß eine eindeutige Ablaufrichtung vorgegeben ist, den Vorteil, daß der Gegenstand eine den ungestörten Transport fördernde Formstabilität erhält, so daß z.B. dessen Vorderkante nicht, wie bei einem ebenen Transport, zum unkontrollierten Ausweichen nach oben und unten neigt und zwischen Transportrollen oder dgl. geraten könnte. Dies gilt in besonderem Maße, wenn die Anlegemittel für eine Haftung an der Förderbahn sorgen. Sie könnten auch eine haftfördernde Oberfläche der Förderbahn umfassen, beispielsweise eine Beschichtung der Transportbänder, die eine gewisse Eigenhaftung zum Material des Gegenstandes ausüben.

Der Gegenstand kann vorteilhaft auf der Förderbahn liegend transportiert werden, so daß die zu behandelnde Oberseite für die Behandlung frei ist und ggf. sogar von oberen Führungsmitteln, wie Rollen oder dgl., freigehalten werden kann. Es wäre allerdings auch möglich, den Transport mit entsprechenden Saugeinrichtungen oder dgl. in gekrümmter Form so durchzuführen, daß die Unterseite frei liegt und die Oberseite an der Förderbahn.

Die die Krümmung der Gegenstände herbeiführende Wölbung der Förderbahn sollte vorzugsweise zu einer horizontalen Querebene symmetrisch sein. Bei bestimmten Bedingungen ist es jedoch auch möglich, davon abzuweichen. Auch die Krümmungsform, die normalerweise einen Kreisbogenabschnitt entspricht, könnte in Abhängigkeit von den Gegebenheiten anders sein, um beispielsweise die Behandlung über die Querachse den Aufbringungs- und Ablaufbedingungen anzupassen, beispielsweise den mit zunehmender Abwärtsneigung zum Rand hin zunehmenden Ablaufgeschwindigkeiten. Das Verhältnis der Krümmungstiefe zur Breite kann von den Eigenschaften des Gegenstandes abhängig sein. Bei der gekrümmten oder einseitig geneigten Ausführung sollte die Neigung zwar so groß sein, daß ein eindeutiger und wirksamer Ablauf gewährleistet ist, jedoch zum Vermeiden des Abwanderns der Gegenstände und anderer sich auch einer zu starken Neigung ergebenden Nachteile so klein wie möglich sein. Dies ist gegeben, wenn die Neigung im Randbereich der Förderbahn zwischen 1° und 10°, bevorzugt 4° bis 6°, gegenüber der Horizontalen beträgt.

Es sollte vorzugsweise dafür gesorgt werden, daß angrenzend an den Randbereich der Förderbahn ein Ablaufraum für das Behandlungsmedium vorgesehen ist.

Die Aufbringemittel für das Behandlungsmedium können zur Aufbringung von oben, vorzugsweise durch Sprühen, vorgesehen sein. Es kann jedoch auch die Aufbringung durch eine Schwallstrecke, d.h. der Durchlauf des Gegenstandes durch eine durch ständiges Nachspeisen von Flüssigkeit entstehende "stehende Welle" vorgesehen sein.

Der Abschnitt mit geneigter und/oder gekrümmter Transportform der Gegenstände kann in andere Behandlungsstrecken mit einbezogen oder an diese angeschlossen werden. So könnte beispielsweise ein Behandlungsabschnitt vor- oder nachgeschaltet werden, in dem die Unterseite der Gegenstände mit einem Behandlungsmedium beschickt wird. In diesem Falle könnte ohne ein Wenden der Gegenstände eine Behandlung von oben und unten her vorgenommen werden.

Es ist festgestellt worden, daß eine Krümmung der Gegenstände im angegebenen Umfange den sehr empfindlichen Oberflächen nicht schadet. Das gilt insbesondere für das Ätzen, bei dem die Einhaltung der Reaktionszeit und die Versorgung mit stets frischem Medium besonders wichtig ist.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnung

Ein Ausführungsbeispiel der Erfindung ist in den Zeichnungen dargestellt und wird im Folgenden näher erläutert. In den Zeichnungen zeigen:
- Fig. 1: die schematische Ansicht einer Förderbahn in Transportrichtung (Querschnitt) und
- Fig. 2: eine schematische Seitenansicht der Förderbahn.

### Beschreibung des Ausführungsbeispiels

Die Zeichnung zeigt schematisch eine Behandlungsvorrichtung 11 für plattenförmige Gegenstände 13. Dabei handelt es sich um meist aus Kunststoff oder Kunststoffverbundwerkstoffen bestehende dünne, fast blattartige Platten, die nach entsprechender Behandlung durch Beschichten, Aufbringen von Leiterbahnen und Wegätzen nicht benötigter Teile als elektronische Leiterplatten verwendet werden. Da die Leiterplatten heutzutage in Vielfachstapelung verwendet werden, sind die Platten sehr dünn und meist nur wenige hundertstel Millimeter dick.

Die Behandlungsvorrichtung umfaßt einen Behälter 12, der unten geschlossen ist und einen Sumpf mit dem Behandlungsmedium, z.B. einer Ätzflüssigkeit, enthält. In diesem langgestreckten, schalenförmigen Behälter ist eine Fördereinrichtung 15 für die Gegenstände 13 vorgesehen, die somit etwa horizontal durch die Behandlungsvorrichtung transportiert werden. Sie treten an einem Einlaß 16 ein und an einem Auslaß 17 aus der Behandlungsvorrichtung wieder aus. Die Förderung dazwischen wird von einem Bandförderer 18 übernommen, der in der schematischen Darstellung mit seinen beiden Umlenkwalzen 19 gezeigt ist, von denen eine drehend angetrieben ist (s. Pfeil 20).

Der Bandförderer 18, der meist relativ lang ist, kann auch in mehreren Abschnitten ausgebildet sein. Auf den Umlenkwalzen 19 läuft ein luftdurchlässiges Förderband 21, das also zahlreiche Löcher 22 aufweist. Paßt sich, wie man erkennt, der Form der Oberfläche 28 und/oder der Umlenkwalzen an und bildet daher eine zur senkrechten Längs-Mittelebene 23 symmetrisch gekrümmte Förderbahn 24 für die Gegenstände 13.

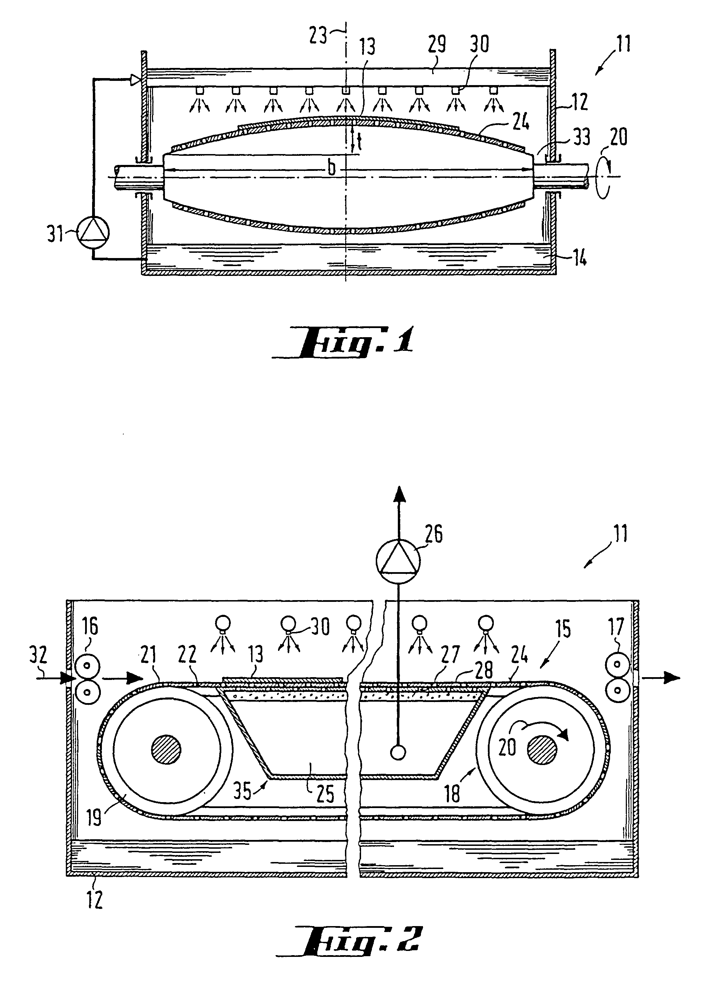

Es läuft zwischen den Umlenkwalzen über eine Saugeinrichtung 25 hinweg, die als ein das Obertrum des Förderbandes 21 beschickender Saugkasten ausgebildet ist und damit Anlegemittel 35 für den Gegenstand an der Förderbahn 24 bildet. Die Saugeinrichtung 25 ist an eine Vakuumpumpe 26 angeschlossen und hat eine mit Löchern 27 versehene Oberfläche 28. Die Oberfläche 28 hat beim Ausführungsbeispiel eine quer zur Transportrichtung 32 gekrümmte Form, die auch der Förderbahn 24 eine entsprechende Gestalt gibt. Zusätzlich können auch die Umlenkwalzen, wie aus Fig. 1 hervorgeht, ballig ausgebildet sein, d.h. ihr Durchmesser kann in der Mitte der Vorrichtung größer sein als an den Rändern. Die Krümmungstiefe t der gekrümmten Mantellinie der Umlenkwalze 19 ist zu der Gesamtbreite b der Walze so bemessen, daß im Randbereich die Neigung der Förderbahn z.B. zwischen 4° und 6° beträgt. Sie ist in der schematischen Zeichnung überhöht dargestellt.

Statt eines luftdurchlässigen Bandes könnte auch ein sich aus mehreren Streifen zusammensetzender Bandförderer vorgesehen sein, bei dem die Saugwirkung in den Zwischenräumen zwischen den einzelnen Bandstreifen ausgeübt wird. Statt einer Saugeinrichtung oder zusätzlich dazu könnten auch andere Anlegemittel Verwendung finden, beispielsweise eine Haftbeschichtung des Bandes oder ähnliche Mittel, um den Gegenstand an der gekrümmten Förderbahn zu halten. Bei Verwendung eines glatten Bandes kann auch die Adhäsionswirkung des Gegenstandes als Anlegemittel dienen; ggf. könnte ein kurzes Andrücken an das Förderband, z.B. durch Rollen, am Einlauf vorgesehen sein. Um ein sicheres Ablösen der Gegenstände vom Förderband sicherzustellen, kann am Auslauf ein Abstreifelement oder z.B. eine Blaslufteinrichtung vorgesehen sein, die gegen die auslaufende Kante der Gegenstände gerichtet ist. Wenn der Gegenstand selbst so flexibel ist, daß er unter seinem Eigengewicht diese Krümmung einnimmt, so könnte auch auf die Anlegemittel verzichtet werden.

Über der Förderbahn 24 sind Aufbringemittel 29 in Form von mehrere Düsen 30 in zahlreichen Gruppen enthaltenen Beschickungsrohren vorgesehen, die mit dem Behandlungsmedium 14 über eine Speisepumpe 31 versorgt werden.

### Funktion

Zur Durchführung eines kontinuierlichen Behandlungsverfahrens für Gegenstände 13 in der Vorrichtung 11 werden diese, von anderen Stationen oder einer Beschickungseinrichtung kommend, in Förderrichtung 32 zum Einlaß 16 in die Vorrichtung einund auf die Förderbahn 15 aufgebracht. Sie legen sich an deren Krümmung unter ihrer Eigenflexibilität, unterstützt durch die Saugwirkung der Saugeinrichtung 25, an und liegen so fest und ohne Abhebeneigung auf dem Förderband 21. Meist reicht schon eine recht geringe Saugwirkung aus, um dies zu bewirken. Um mit geringeren Leistungen der Vakuumpumpe 26 auszukommen, könnte die Saugeinrichtung auch in mehrere Längssektoren unterteilt sein, die entsprechend der Breite der verarbeiteten Gegenstände beaufschlagt werden. Ggf. könnten als Saugeinrichtung auch zwei oder mehrere schmale Saugleisten in einigem Abstand von der Mittelebene 23 ausreichen, um die gewünschte Anpassung an die Förderbahn zu gewährleisten.

Aus den Düsen 30 der Aufbringemittel wird das Behandlungsmedium 14 auf die Oberseite der Gegenstände aufgesprüht. Es kann von dort sofort nach beiden Seiten hin ablaufen, da die behandelte Oberfläche der Gegenstände zu beiden Seiten hin abfallend gekrümmt ist. Ferner wird durch den Versteifungseffekt des gekrümmten Gegenstandes auch vermieden, daß irgendwelche Einsenkungen entstehen, die eine Pfütze bilden könnten. Das Behandlungsmedium läuft also über die Seite der Förderbahn ab. An den Seiten der Behandlungsvorrichtung ist neben der Förderbahn dafür gesorgt, daß ausreichende Ablaufräume 33 vorhanden sind, durch die das Medium von der Förderbahn in den Sumpf zurückwerfen kann. Normalerweise wird es von dort, ggf. nach einer Filterung, Reinigung oder Auffrischung, in den Behandlungskreislauf zurückgeführt. Der Vakuumpumpe 26 kann ein nicht dargestellter Flüssigkeitsabscheider vorgeschaltet sein, um in die Saugeinrichtung eindringendes Behandlungsmedium abzuscheiden.

Nach dem Durchlaufen der Behandlungsstrecke und nach dem Verlassen der Saugeinrichtung 25 wird der Gegenstand, der nun wieder eine ebene Gestalt annehmen kann, aus dem Auslaß 17 aus der Vorrichtung ausgeschleust.

## Patentansprüche

1. Vorrichtung zum Behandeln von platten- bzw. blattförmigen Gegenständen (13), insbesondere Leiterplatten, mit Aufbringemitteln (29) zur Aufbringung eines flüssigen Behandlungsmediums (14), insbesondere durch Sprühen, wobei zumindest in einem Behandlungsabschnitt die Gegenstände (13) längs einer Förderbahn (24) etwa horizontal angeordnet durch die Vorrichtung transportiert werden, wobei die Förderbahn (24) zumindest im Randbereich gegenüber der Horizontalen geneigt ist, **dadurch gekennzeichnet, daß** die Förderbahn (24) wenigstens einen Bandförderer (18) enthält und daß die Förderbahn (24) die Anlage der Gegenstände an der Förderbahn unterstützende Anlegemittel (25) aufweist.

2. Vorrichtung nach Anspruch 1, **dadurch gekennzeichnet, daß** die Förderbahn (24) zur Förderung flexibler Gegenstände (13) quer zur Förderrichtung (32) gekrümmt ist.

3. Vorrichtung nach Anspruch 1 oder 2, **dadurch gekennzeichnet, daß** die Anlegemittel (24) eine Saugeinrichtung umfassen, die vorzugsweise einen unter einem ggf. gelochten Förderband angeordneten Vakuumkasten aufweist.

4. Vorrichtung nach einem der Ansprüche 1 bis 3, **dadurch gekennzeichnet, daß** die Anlegemittel eine selbsthaftende bzw. haftfördernde Oberfläche der Förderbahn (24) umfassen, und ggf. Andrückmittel am Einlauf und/oder Ablösemittel am Auslauf.

5. Vorrichtung nach einem der vorhergehenden Ansprüche, **dadurch gekennzeichnet, daß** die Gegenstände (13) auf der Förderbahn (24) liegend transportiert werden.

6. Vorrichtung nach einem der vorhergehenden Ansprüche, **dadurch gekennzeichnet, daß** die Wölbung der Förderbahn (24) zu einer vertikalen Längs-Mittelebene (23) der Förderbahn (24) symmetrisch ist.

7. Vorrichtung nach einem der vorhergehenden Ansprüche, **dadurch gekennzeichnet, daß** die Neigung der Förderbahn (24) zwischen 1° und 10°, vorzugsweise 4° bis 6° beträgt.

8. Vorrichtung nach einem der vorhergehenden Ansprüche, **dadurch gekennzeichnet, daß** an den Seiten der Förderbahn (24) Ablaufräume (33) vorgesehen sind.

9. Vorrichtung nach einem der vorhergehenden Ansprüche, **dadurch gekennzeichnet, daß** einem Behandlungsabschnitt, in dem die Oberseite der gekrümmt transportierten Gegenstände (13) mit dem Behandlungsmedium (14) behandelt werden, ein Behandlungsabschnitt vor- oder nachgeschaltet ist, in dem die Unterseite der Gegenstände mit Behandlungsmedium beschickt wird.

## Claims

1. Apparatus for treating plate-like or foil-like articles (13), particularly printed circuit boards, with application means (29) for the application of a liquid treatment medium (14), particularly by spraying, where at least in one treatment portion the articles (13) are conveyed roughly horizontally along a conveyor (24) through the apparatus and at least in the marginal area the conveyor (24) is inclined relative to the horizontal, **characterized in that** the conveyor (24) contains at least one belt conveyor (18) and that the conveyor (24) has contacting means (25) assisting the contacting of the articles with the conveyor.

2. Apparatus according to claim 1, **characterized in that** the conveyor (24) is curved transversely to the conveying direction (32) for conveying flexible articles (13).

3. Apparatus according to claim 1 or 2, **characterized in that** the contacting means (24) comprise a suction device, which preferably has a vacuum box arranged below an optionally perforated conveyor belt.

4. Apparatus according to one of the claims 1 to 3, **characterized in that** the contacting means comprise a self-adhering or adhesion-aiding surface of the conveyor (24) and optionally pressing means at the inlet and/or detaching means at the outlet.

5. Apparatus according to one of the preceding claims, **characterized in that** the articles (13) are conveyed lying on the conveyor (24).

6. Apparatus according to one of the preceding claims, **characterized in that** the convexity of the conveyor (24) is symmetrical to a vertical median longitudinal plane (23) of the conveyor (24).

7. Apparatus according to one of the preceding claims, **characterized in that** the inclination of the conveyor (24) is between 1 and 10°, preferably 4°and 6°.

8. Apparatus according to one of the preceding claims, **characterized in that** discharge spaces (33) are provided on the sides of the conveyor (24).

9. Apparatus according to one of the preceding claims, **characterized in that** upstream or downstream of a treatment portion where the top of the curved conveyed articles (13) is treated with treatment medium is provided a treatment portion where the treatment medium is supplied to the bottom of the articles.

## Revendications

1. Dispositif pour le traitement d'objets (13) en forme de plaque ou encore de feuille, notamment des plaques à circuits imprimés, avec des moyens d'application (29) pour l'application d'une matière de traitement (14) liquide, en particulier par aspersion, les objets (13) étant transportés au moins dans un secteur de traitement le long d'une voie de transport (24) disposés à peu près en horizontale à travers le dispositif, la voie de transport (24) étant inclinée par rapport à la horizontale au moins dans le domaine marginal, **caractérisé en ce que** la voie de transport (24) comprend au moins un convoyeur à bande (18) et **en ce que** la voie de transport (24) présente des moyens de mise en contact (25) qui favorisent la mise en contact des objets avec la voie de transport.

2. Dispositif d'après la revendication 1, **caractérisé en ce que** la voie de transport (24) est courbée pour le transport d'objets (13) fléxibles transversalement par rapport à la direction de transport (32).

3. Dispositif d'après la revendication 1 ou 2, **caractérisé en ce que** les moyens de mise en contact (24) comprennent un moyen d'aspiration, qui présente de préférence une chambre à vide disposée au-dessous d'une bande transporteuse éventuellement perforée.

4. Dispositif d'après une des revendications de 1 à 3, **caractérisé en ce que** les moyens de mise en contact comprennent une surface adhérente en elle-même ou encore favorisant l'adhérence de la voie de transport (24), et éventuellement des moyens de contre-pression à l'entrée et/ou des moyens de détachement à la sortie.

5. Dispositif d'après une des revendications précédentes, **caractérisé en ce que** les objets (13) sont convoyés de manière couchée sur la voie de transport (24).

6. Dispositif d'après une des revendications précédentes, **caractérisé en ce que** la convexité de la voie de transport (24) est symétrique par rapport à un plan médian longitudinal (23) de la voie de transport (24).

7. Dispositif d'après une des revendications précédentes, **caractérisé en ce que** l'inclinaison de la voie de transport (24) comporte entre 1° et 10°, de préférence de 4° à 6°.

8. Dispositif d'après une des revendications précédentes, **caractérisé en ce que** sur les côtés de la voie de transport (24) sont prévus des espaces de déversement (33).

9. Dispositif d'après une des revendications précédentes, **caractérisé en ce que** par rapport à une section de traitement, dans laquelle sont traités avec une matière de traitement (14) les faces supérieures des objets (13) convoyés de manière courbée une section de traitement est intercalée en amont ou en aval, dans laquelle la face inférieure des objets est alimentée en matière de traitement.
